# EUROPEAN PATENT APPLICATION

(11) **EP 1 713 126 A1**
(43) Date of publication of application: **18.10.2006**
(21) Application number: 05008218.9
(22) Date of filing: 14.04.2005
(51) Int. Cl.: H01L 27/146, H01L 27/148, H01L 31/0203, H01L 31/0232

(54) **Image pickup device and a manufacturing method thereof**

(71) Applicant: Tseng, Shih-Hsien, Hsinchu, Taiwan, R.O.C (TW)
(72) Inventor: Tseng, Shih-Hsien, Hsinchu, Taiwan, R.O.C (TW)
(74) Representative: Weber, Joachim

(57) **Abstract**

A thin image pickup device has a substrate, an electromagnetic receiving area thereon as photoelectric converting elements, a peripheral circuit, and embedded trenches passing through the substrate and filled with conductive materials for forming stitching plugs. The stitching studs are formed from the stitching plugs after a lower surface of the substrate being thinned, and serve as electrode connecting terminals of the image pickup device.

## Description

### BACKGROUND OF THE INVENTION

### Field of Invention

The present invention relates to an image pickup device. More particularly, the present invention relates to a thin image pickup device manufactured by using a whole wafer, and one or more image producing steps that thin the image substrate and cover the optical transparent window directly. Furthermore, an optical lens system, a solid-state image pickup device, an image control module, a flexible conductive element and other devices are integrally assembled in a compact imaging module device suitable for integration into a unit of portable electronic equipment.

### Description of Related Art

Generally, an image pickup device is mounted in a ceramic or plastic package on a flexible or plastic circuit board by wiring or bumping pads of the image pickup device to inner leads of the package, and thus forming an image pickup device. The image pickup device typically comprises a photoelectric transducer element fabricated on an upper surface of a solid-state semiconductor substrate, which is capable of converting incident electromagnetic radiation energy thereon into an electronic charge and then transforming the same into a controlled electrical voltage signal. Moreover, a pixel addressing control circuit decodes active pixel elements of the photoelectric transducer array and a peripheral control circuit is also provided for a signal output from the image pickup device.

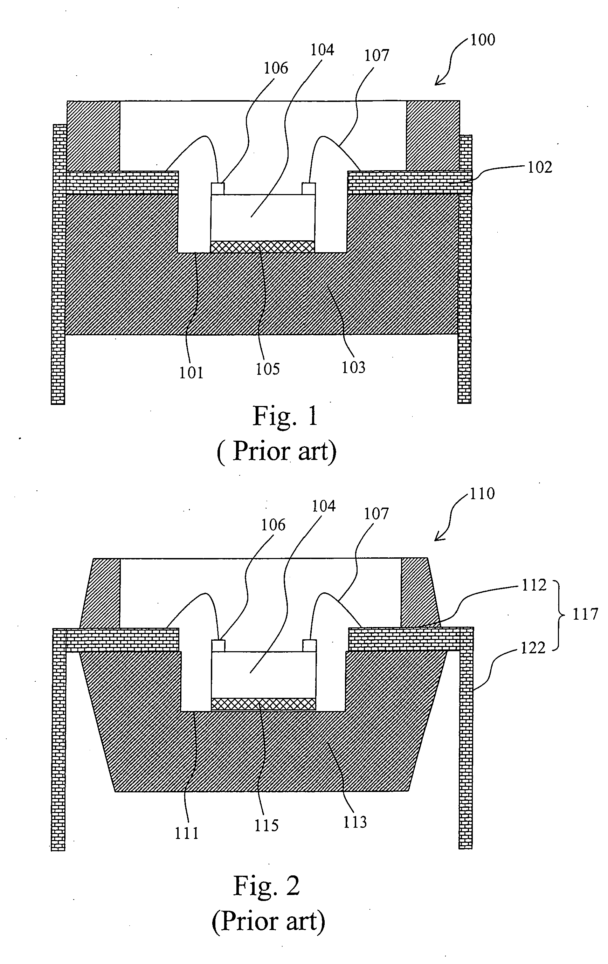

The image pickup device is individually assembled and hermetically sealed in the ceramic or plastic package having signal lead terminals and a cover glass, plastic lid or window that exposes the top of the photoelectric transducer element of the image pickup device. Fig. 1 illustrates a schematic view of a conventional image pickup device and package. As illustrated in Fig. 1, a conventional ceramic package 100 is provided with a recess 101 on a ceramic substrate 103 and a conductive inner lead 102 therein. An image pickup device 104 is attached inside the recess 101 with a conductive adhesive film 105, and a standard wire bonding process is used to connect electrode pads 106 of the image pickup device 104 to the inner leads 102 with metal wires 107.

Fig. 2 illustrates a schematic view of another conventional image pickup device and its package. In Fig. 2, a resin package 110 has an electrical connecting molded lead frame 117 comprising inner leads 112 and outer leads 122, and a recess 111 on a resin substrate 113. An image pickup device 104 is attached inside the recess 111 by a conductive adhesive film 115, and a wire bonding process is also used to connect electrode pads 106 of the image pickup device 104 to the inner leads 112 with metal wires 107.

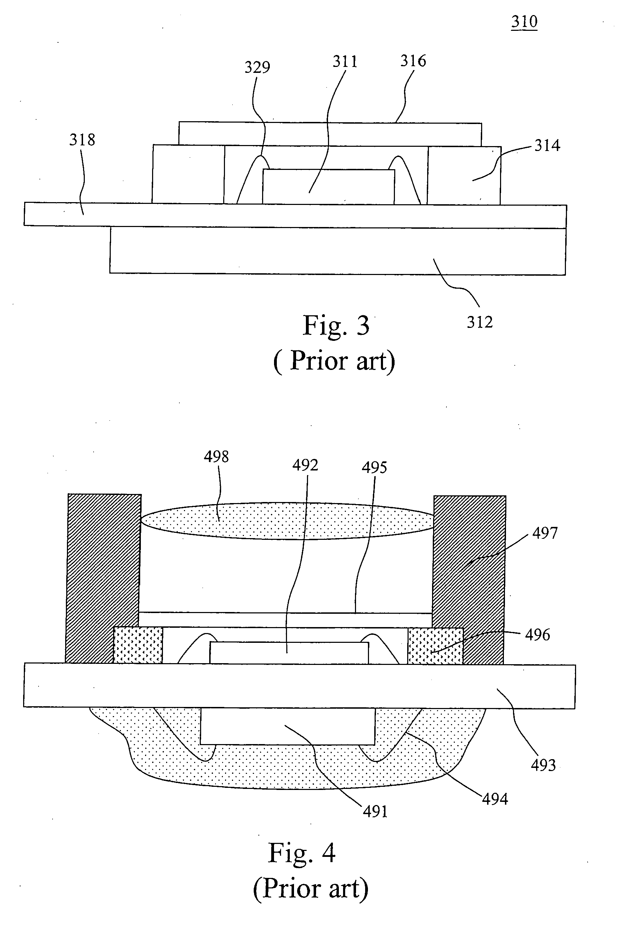

Another low cost image package is disclosed in U.S. Pat. No. 6268231, entitled "Low cost CCD packaging" and issued on Oct. 14, 1999 to Keith E. Wetzel, as illustrated in Fig. 3. A CCD package 310 includes a plastic base structure 312, a plastic ring frame 314, a flexible circuit board 318 and a cover glass 316 to form a hermetic housing, in order to contain and assemble an image pickup device inside it. The cover glass 316 is used to protect the image sensor chip 311 attached on the flexible circuit board 318 inside the hermetic housing. Conductive leads of the flexible circuit board 318 are electrically connected to electrode pads of the image sensor chip 311 by metal bonding wires 329.

The major disadvantages of the conventional image pickup device are that it is manufactured by individual assembling processes, without thinning the image pickup substrate before the sequential assembling steps, complicated wire bonding steps are required, thus increasing the overall manufacturing cost and cycle time, and it is further difficult to miniaturize the size and weight thereof. Generally, multiple image pickup devices of the solid-state wafer need to be first separated therefrom into single individual image pickup devices. However, during the wafer singulation, the induced silicon particles tend to contaminate and scratch the photoelectric transducer area of the image pickup device and thereby damage or destroy the image pickup device, thus affecting the overall assembling yield and quality of the image pickup devices.

As portable electronic equipment becomes smaller, lighter, and thinner, it is critical to miniaturize the size of the image pickup device integrated in the portable electronic equipment. The conventional image pickup device described above requires a housing, supporting the transparent glass and maintaining a space for containing and protecting wire bonding loops thereof.

However, the housing is relatively bulky and has to extend upwards from the circuit board with a significant distance of at least a couple of millimeter (mm). Moreover, trapped moisture inside the housing causes failure and lowers the sensitivity of the image pickup device. As the function and quality performance of the image pickup device improve following the demands of new various multimedia applications of portable electronics equipments, a number of optical lenses and peripheral signal control circuit components have to be included and assembled together.

Therefore, it is very difficult to assemble with precision a smaller and thinner image pickup device into an integrated and miniaturized image pickup module, including optical lens system and peripheral controlled devices to maintain the high quality and performance of the image pickup device.

The related-art imaging pickup module is illustrated in Fig. 4. involves a peripheral element 491, an imaging pickup element 492, and a circuit board 493. A wire bonding is carried out using a metal wire 494 for the electrical connection between the image pickup element 492 and the circuit board 493 in the resin housing having a cover glass 495 or IR filter adhered to the resin 496. Then a holder 497 having an optical lens 498 is mounted on the circuit board 493. However, there are some problems in maintaining precise alignment and focus between the image pickup element 492 and the optical lens 498, and a thickness of holder 497 and this imaging pickup module configuration are not suitable to make smaller and thinner imaging pickup modules.

In this way, the accuracy of positioning of the optical lens system with respect to the solid-state image pickup device is inferior to the conventional image pickup module, Furthermore, considering a moveable-type focal lens system, focusing of the moveable-type focal lens system with respect to the image pickup device is carried out by the focal length adjusting mechanism, which needs lens-barrels for focal length adjustment so that the image pickup module becomes large and complicated.

### SUMMARY OF THE INVENTION

The present invention is provided to resolve the above-described concerns regarding image pickup devices and to disclose a cheap, thin and compact image pickup module for installation in a cellular phone, a personal computer, a video camera, a digital still camera, a personal digital assistant (PDA), a desktop scanner, a bar-code reader, a security scanner, or the like.

It is therefore an objective of the present invention to provide a thin image pickup device, which is easily assembled and flexibly mass produced on a whole wafer or a partial wafer with multiple image pickup devices, and is a miniaturized and highly integrated functional device.

It is another objective of the present invention to provide an imaging module, which has a fixed or adjustable optical lens system suitable for installation on a portable electronic device, such as a mobile telephone or a personal digital assistant.

It is still another objective of the present invention to provide a manufacturing method of an image pickup device, which uses stitching studs to replace the conventional wirings and substantially thins the substrate, such that the image pickup device is more adaptable to modern thin, light and small electronic devices.

In accordance with foregoing and other objectives of the present invention, a thin image pickup device is provided. The thin image pickup device includes a substrate, an electromagnetic receiving area thereon as photoelectric converting elements, a peripheral circuit, and embedded trenches filled with conductive materials for forming stitching plugs. The stitching studs are formed from the stitching plugs after a lower surface of the substrate is thinned, and serves as electrode connecting terminals of the image pickup device.

In one preferred embodiment of the invention, a transparent window is attached onto the substrate, and located above the electromagnetic receiving area for improving the image quality. A sustain layer can be used to prevent the transparent window from damaging the photoelectric converting area and to control a pre-designed thickness between the photoelectric converting area and the transparent window, which are recognized as a partial image optical system implemented in the image pickup device. Moreover, a plurality of adhesive layers are provided for combining the transparent window, the sustain layer and the substrate.

The transparent window is attached directly onto an upper surface of the image pickup device of the invention, without additionally forming a housing to support the transparent window that protects the image pickup device. The transparent window can alternatively have one or two flat, spherical, aspherical, or Kinoform surfaces.

The surfaces of the transparent window are diffractive, refractive surfaces or hybrid surfaces, including flat, spherical, aspherical surfaces or any combination thereof to be refractive or diffractive optic elements, for performing an optical function of the optical lens system. The surfaces also can be formed with at least one film to provide IR and/or low pass filter features. When the transparent window is subjected to optical filter treatment, it need not be re-matched with a new optical filter and a new cover glass on the image pickup device.

The transparent window is attached onto the upper surface of the image pickup device with an adhesive film directly and/or combined with a sustain layer. For completely tightening the lower surface of transparent window and the top surface of the image pickup device , holes and/or extrusions can be provided on the image pickup device , the sustain layer, the adhesive layer and the transparent window for a precise alignment between the image pickup device and the transparent window.

Furthermore, in another embodiment of the invention, a transparent material fills a cavity between the upper surface of the photoelectric converting area and the lower surface of the transparent window. The transparent material matches a reflective index of the transparent window to reduce the reflection loss between the image pickup device and the transparent window directly attached thereto. This configuration achieves the image formation on the photoelectric converting elements through the transparent window and/or the transparent material filler.

Thereafter, the substrate is thinned directly from the lower surface thereof by using conventional backgrinding and/or subsequent polishing, such as chemical-mechanical polishing, high selective plasma etching, or wet etching steps, to expose the embedded deep metal plugs to be the stitching studs, which are electrode connecting terminals of the image pickup device.

The embedded deep metal plugs are formed from the embedded trenches dug in the upper surface of the substrate by plasma etching, wet etching, laser drilling or any combination thereof, and then depositing the insulating films, such as silicon dioxide, silicon nitride, other insulating films or any combination thereof, by alternative techniques to form on the sidewall of the embedded trenches.

The embedded trenches are then filled with conductive materials, such as titanium, titanium nitride, aluminum, copper, mercury, tungsten, amalgam, silver epoxy, solder, conductive polymer, other conductive material or their combinations, for example.

In the manufacturing method, a plurality of stitching studs are formed from the lower surface of the substrate as external electrode connecting terminals without increasing the weight or bulk of the package. More particularly, the method is not limited to using a single image pickup packaging process; more flexible and efficient processes, such as a whole wafer or multiple image pickup devices assembling process, may also be used.

In other preferred embodiments, the invention provides several different ways for forming the stitching studs. The lower surface of the substrate is etched to form a plurality of backside trenches corresponding to and in contact with the frontside stitching plugs. An insulating film is formed on the sidewalls of the backside trenches and then the backside trenches are filled with a conductive material, thus forming backside stitching plugs. The backside stitching plugs are electrically connected to the frontside plugs, thus forming the stitching studs.

Alternatively, it is possible to form the stitching studs, directly from the lower backside, as external electrode connecting terminals without increasing any weight or bulk of the package thereof. After thinning the substrate or not, one backside stitching stud is formed by a single backside trench which passes through the substrate from the lower surface to the upper surface thereof, and is also covered with an insulating film. The stitching stud is connected to an electrical connection layer which may be a poly or polycide layer, a contact plug, or a metal layer fabricated in the image pickup device.

Furthermore, in another preferred embodiment, an electrical connecting configuration is provided to connect electrically the stitching studs to electrode ports of an image control module, which has highly integrated image related control functional blocks, such as system micro controllers, digital signal processing units, system timing ASICs, memory buffers and peripheral controller devices, or has integrated image system control module packages including the preceding functionality.

Several packaging connection techniques and materials, such as an isotropic conductive adhesive used in the stud bumping bonding anisotropic connection film (ACF), gold or solder bumping, wiring, ball grid array, flexible cable and/or flip chip, can be used in the electrical connecting between the stitching studs and the electrode ports of the image control module, to be an integrated compact imaging module.

In keeping with the trend for portable electronic multimedia equipment, a requirement of a compact imaging module integrated into such equipment is greater than ever. Generally, an optical lens system is individually and fixedly combined with a lens holder configured on the substrate having the image pickup device mounted by conventional assembling techniques. Or, a complicated zoom cam mechanism is used to adjust the focal length of the optical lens system with the respect to the image pickup device.

The present invention also provides a cheap, compact, highly functional and producible imaging module, which has an easily assembled optical lens system with a fixed focus or an adjustable focus combined with the thin image pickup device manufactured by the foregoing method. By forming a plurality of image pickup modules simultaneously, labor for handling and producing the image pickup modules is less than that with the conventional method, which handles and produces the image pickup modules on an individual basis.

A plurality of adhesive layers and optional sustain layers are formed in a stacked manner, which can be the lens holder for attaching and holding the optical lens system to and with respect to the transparent window configured on the substrate. The adhesive layers are deposited above the transparent window, then the sustain layers and other adhesive layers are optionally inserted to maintain the pre-designed focal length. A precisely controlled focal length is thus available between the optical lens system and image pickup device.

The configuration of the invention is suitable for depositing the adhesive layers and the sustain layers in between to match the transparent window and attach the optical lens system by manufacturing on a whole wafer or multiple image processes simultaneously. After that, each of the image pickup devices is separated to electrically connect to the electrode ports of the image control module, which includes and/or is bonded to a plurality of peripheral devices in a stacked or planar manner on the same circuit board.

The configuration of the invention also achieves an adjustable focus imaging module by using a flexible conductive element electrically connected between the image pickup device and the image control module, where the moveable focus imaging module includes the optical lens system and the image pickup device which are tightly combined with each other by a zoom mechanism or other techniques, such as mechanical techniques, electromagnetic force or motors, to facilitate upward and downward movements of the image pickup device and/or the optical lens system so that the image performance and quality are further improved.
Other objects, features, and advantages of the present invention will become apparent upon consideration of the following detailed descript and accompanying drawings, in which like reference designations represent like features throughout the figures. It is to be understood that both the foregoing general description and the following detailed description are examples, and are intended to provide further explanation of the invention as claimed.

### BRIEF DESCRIPTION OF THE DRAWINGS

These and other features, aspects, and advantages of the present invention will become better understood with regard to the following description, appended claims, and accompanying drawings where:
Fig. 1 illustrates a schematic view of a conventional image pickup device and its package;
Fig. 2 illustrates a schematic view of another conventional image pickup device and its package;
Fig. 3 illustrates a schematic view of another conventional image pickup device and its package;
Fig. 4 illustrates a schematic view of relative-art pickup module;
Fig. 5 illustrates a schematic view of a whole wafer having a plurality of image pickup devices;
Fig. 6 is a schematic view of the image chip in Fig. 5;
Fig. 7A to Fig. 7D are cross-sectional views along the line A-A' in Fig. 6 for illustrating a manufacturing method of the stitching plugs;
Fig. 8 is a cross-sectional view along the line A-A' of the image chip in Fig. 6 for interpreting the sequential processes after the step in Fig. 7D;
Fig. 9A and Fig. 9B are schematic views to illustrate fabrication steps of multiple image chips and the transparent windows attached thereto;
Fig. 10A and Fig. 10B illustrate schematic views of other preferred embodiments of the invention;
Fig. 11 A and Fig. 11B illustrate schematic views of the substrate which are thinned from lower surfaces of the substrate in Fig 10A and 10B, respectively;
Fig. 12A and Fig. 12B illustrate schematic views of another preferred embodiments of the invention;
Fig. 13A, Fig. 13B and Fig. 13C illustrate schematic views of three embodiments of the invention showing how to form the stitching studs in different ways;
Fig, 14A and Fig. 14B illustrate schematic views of preferred embodiments of the image pickup device associated with an image control module;
Fig. 15A and Fig. 15B illustrate schematic views of two embodiments of the imaging module of the invention, which have fixed focal lengths; and
Fig. 16A and Fig. 16B illustrate schematic views of two embodiments of the imaging module of the invention, which have adjustable focal lengths.

### DESCRIPTION OF THE PREFERRED EMBODIMENTS

Reference will now be made in detail to the present preferred embodiments of the invention, examples of which are illustrated in the accompanying drawings. Wherever possible, the same reference numbers used in the drawings and the description refer to the same or like parts.

An image device includes a substrate, a photoelectric converting area, a transparent window and a plurality of stitching studs. The photoelectric converting area detects image radiation energy. The transparent window improves image quality. The stitching studs on the bottom side of the substrate electrically connects to an image control module having highly integrated and other image-related function blocks, such as system microcontrollers, digital signal processing units, system timing ASICs, memory buffers and peripheral controller devices, or having integrated image system control module packages including the preceding functionality. Moreover, an optical lens system for improving image performance and quality is fixedly or adjustably configured to the image pickup device.

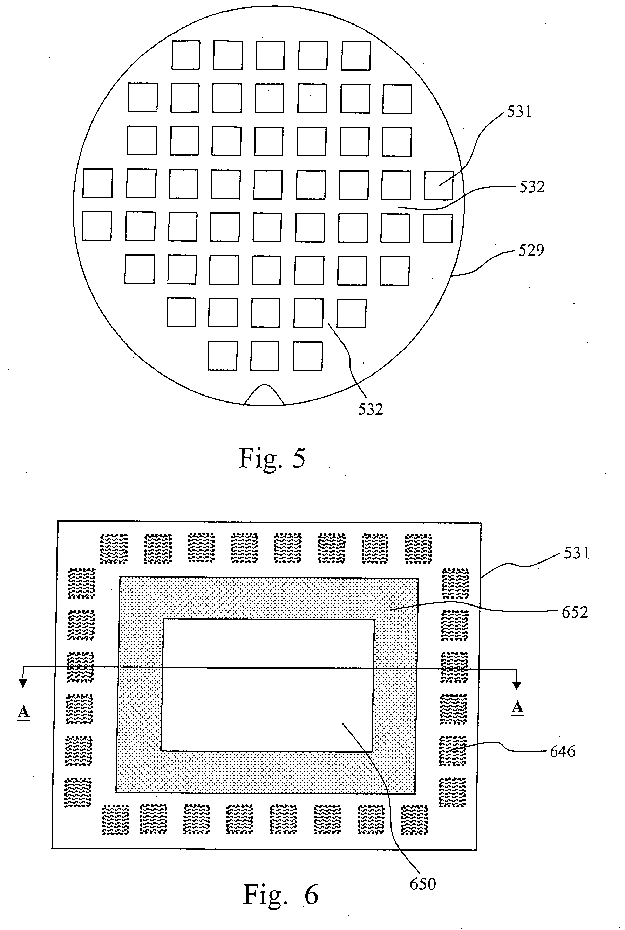

Fig. 5 illustrates a schematic view of a whole wafer having a plurality of image pickup devices. In Fig. 5, a whole wafer 529 is sliced from a single crystal silicon ingot and manufactured under a CMOS image sensor (CIS) or a charge couple device (CCD) process. The wafer 529 comprises a plurality of image pickup devices, e.g. an image chip 531, and dice saw area 532 which is reserved for the wafer 529 being cut into the individual image chip 531.

Fig. 6 is a schematic view of the image chip 531 in Fig. 5. As illustrated in Fig. 6, the image chip 531 has an electromagnetic receiving area, i.e. a photoelectric converting element 650 in the central location of the image chip 531, and also has a plurality of stitching plugs 646 arranged along the perimeter of a peripheral circuit 652 thereof which is connected to an image control module by the conventional electrical terminal connection processes.

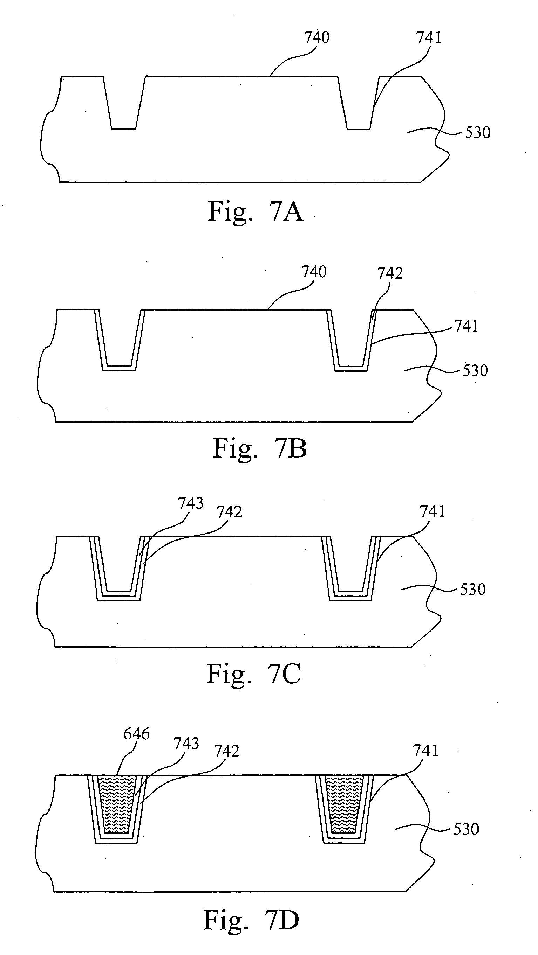

Fig. 7A to Fig. 7D are cross-sectional views taken along the line A-A' in Fig. 6 to illustrate a manufacturing method of the stitching plugs. Referring to Fig. 7A, a substrate 530 is etched on an upper surface 740 thereof to form a plurality of trenches 741. In one embodiment of the present invention, the trenches 741 are formed on a silicon semiconductor substrate or other silicon semiconductor substrates with a sapphire layer, such as substrates used in a semiconductor over insulator (SOI) technology, or even other plastic or glass substrates.

As illustrated in Fig. 7B and Fig. 7C, for isolating the trenches 741, insulating films are formed inside the trenches 741, including an oxidization film 742 and/or an additional silicon nitride film 743. The trenches 741 are then filled with a conductive material to form the isolated stitching plugs 646, as shown in Fig. 7D. In one preferred embodiment of the invention, the conductive material is either titanium or titanium nitride when the electrical connecting plug is buried metals and tungsten. In other preferred embodiments, the conductive material is titanium, titanium nitride, aluminum, copper, mercury, tungsten, amalgam, silver epoxy, solder, conductive polymer, other conductive material, or combinations thereof.

Then, chemical mechanical polishing (CMP), wet etching, plasma etching back processes or a combination thereof is applied to accomplish the isolated stitching plugs 646. The stitching plugs 646 embedded inside the substrate 530 are expected to be outer electrode pads after the foregoing conventional solid state process steps. Generally, the sequence of forming the stitching plugs 646 is flexible in a serial of manufacturing steps of the image pickup device. For example, the step of forming the stitching plugs 646 can be carried out before or after the step of forming an interlayer dielectric layer (ILD) and metal layers, forming contact or via layers, forming poly layers, or forming a photodiode active layer of the photoelectric converting element 650.

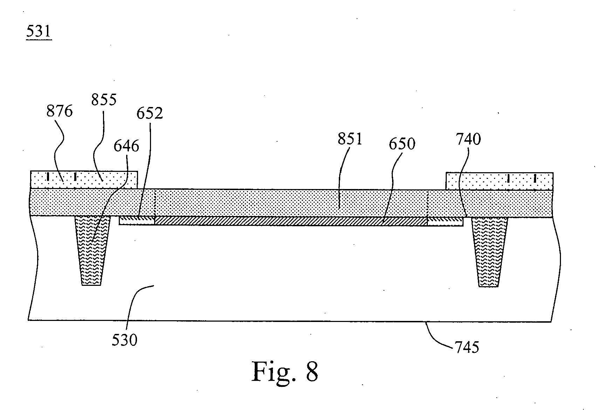

Fig. 8 is a cross-sectional view taken along the line A-A' of the image chip 531 in Fig. 6 to interpret the sequential steps after the step illustrated in Fig. 7D. The photoelectric converting element 650 is formed on the upper surface 740, and is generally located in the central region of the image chip 531. A peripheral circuit 652 for address decoding and signal processing is located in a peripheral region of the photoelectric converting element 650, which has a large number of pixels (not shown) disposed in two dimensions.

Each pixel comprises a photodiode and a CMOS transistor for amplifying converted charges, and switching according to the radiation amount of electromagnetic density. In addition, the peripheral circuit 652 also comprises a driving circuit for driving the pixels to obtain signal charges, an A/D converter for converting the signal charges to digital signals, and a digital signal processing unit for forming image output signals.

Several inter-dielectric layers 851 are located on the photoelectric converting element 650 and the peripheral circuit 652. The inter-dielectric layers 851 may include a poly and/or metal. A color filter, a micro lens array layer (not illustrated in Fig. 8), or a passivation layer 855 is on the inter-dielectric layers 851. The inter-dielectric layers 851 are formed by semiconductor processes; thus make the whole configuration able to perform the function of an image pickup device. In addition, the stitching plugs 646 are configured near the perimeter of the peripheral circuit 652, and arranged closely to one another.

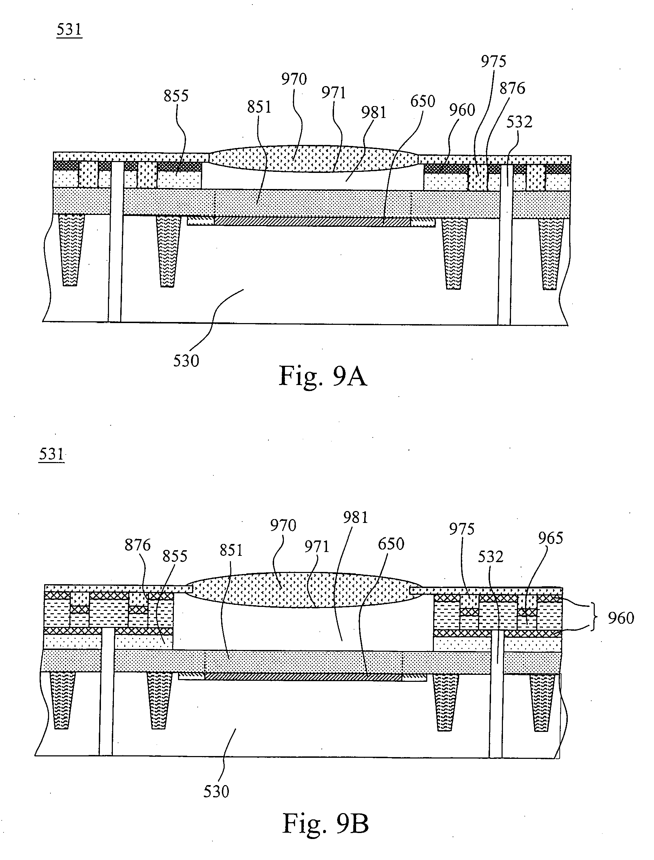

Fig. 9A and Fig. 9B are schematic views illustrating fabrication steps of multiple image chips and the transparent windows attached thereto. As illustrated in Fig. 9A, an adhesive layer 960 is sandwiched between the substrate 530 and the transparent window 970. In addition, as illustrated in Fig. 9B, the adhesive layer 960 also can optionally be inserted with a sustain layer 965 to prevent the transparent window 970 from damaging the photoelectric converting elements 650. The adhesive layer 960 also can be applied between a passivation layer 855 and a lower surface 971 of the transparent window 970.

The transparent window 970 is matched with the substrate 530 in terms of either a whole wafer or image chips. The transparent window 970 shields the photoelectric converting element 650 and improves the image performance thereof. It also may perform as an IR filter or a low pass filter.

Furthermore, the transparent window 970 may have one or two flat, spherical, aspherical, or Kinoform surfaces or a further hybrid combined with flat, spherical and/or aspherical surfaces to provide the functions of a refractive or diffractive optic element.

Color filters can be formed on the transparent window 970 to color images while the image pickup device is a mono-color device. The alignment and adhesive portions can be integrally formed together between the substrate 530 and the transparent window 970, such as extrusions 975 of the transparent window 970 and holes 876 of the sustain layer 965, as illustrated in Fig. 9A and Fig. 9B. The extrusions 975 and the holes 876 are formed by the conventional semiconductor patterning and etching, glass, or plastic molding process. Alternatively, holes may be formed on the transparent window 970 for mechanical alignment with the extrusions of the substrate 530.

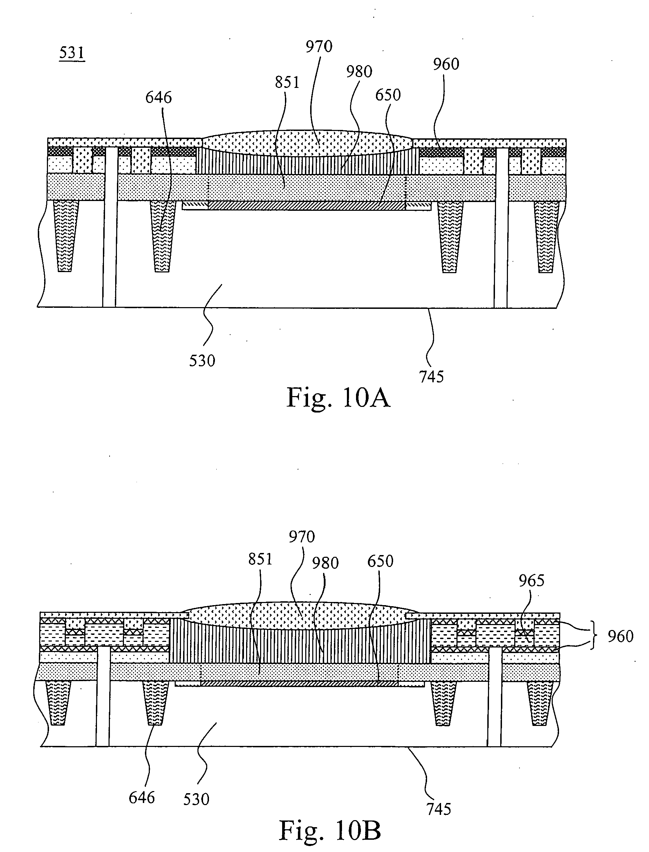

Fig. 10A and Fig. 10B illustrate schematic views of other preferred embodiments of the invention. In these preferred embodiments, a cavity 981 between the transparent window 970 and the inter-dielectric layers 851, is filled with transparent material 980 instead of air as illustrated in Fig. 9A and Fig. 9B. The transparent material 980 can be silicone epoxy, silicon gel, polymer, polyimide, liquid crystal, plastic or other gases, which properly fills the cavity 981. More particularly, the transparent material 980 and the transparent window 970 protect the photoelectric converting element 650 from dust and contaminants as so to improve the sensitivity of the photoelectric converting element 650.

The substrate 530, the transparent window 970 and/or the transparent material 980 are combined by the adhesive layer 960, even when the sustain layer 965 or other adhesive layers are also used, such that the semi-manufactured device can be stored out of a clean room before subsequent assembling procedures proceed. In other words, the cost associated with the image pickup device of the invention is less than that in the prior arts.

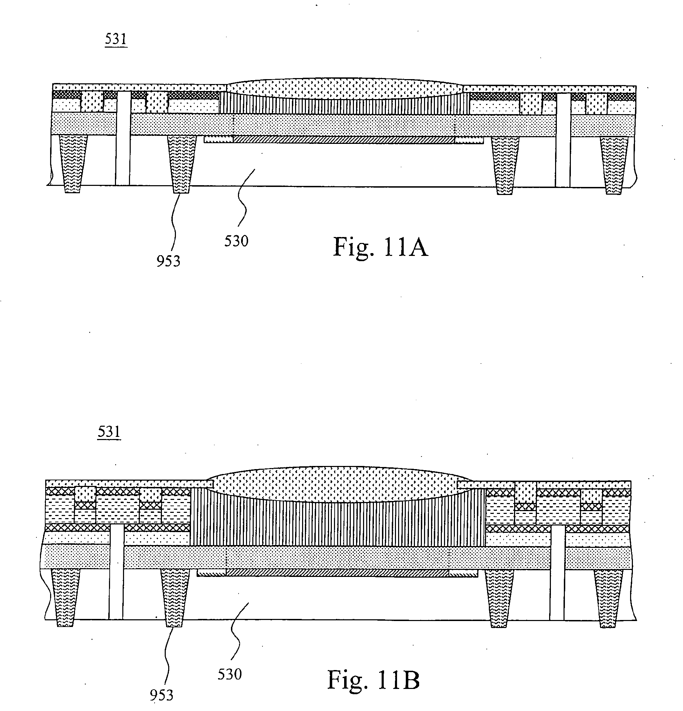

Fig. 11A and Fig. 11B illustrate schematic views of the substrate which is thinned from lower surfaces of the substrate illustrated in Fig 10A and 10B, respectively. The substrate 530 in Fig. 10A or Fig. 10B is thinned by backside grinding, chemical mechanical polishing (CMP), high selective plasma etching or wet etching from the lower surface 745, so that bottom ends of the stitching plugs 646 are exposed from the lower surface 745 of the substrate 530 as illustrated in Fig. 11A and Fig. 11B. Stitching studs 953 are then formed from the stitching plugs 646 to perform as outer electrode connecting ports. Moreover, the stitching studs 953 can be coated with layers of UBM (Under Bump Metallurgy) (not illustrated in Fig. 11A and Fig. 11B).

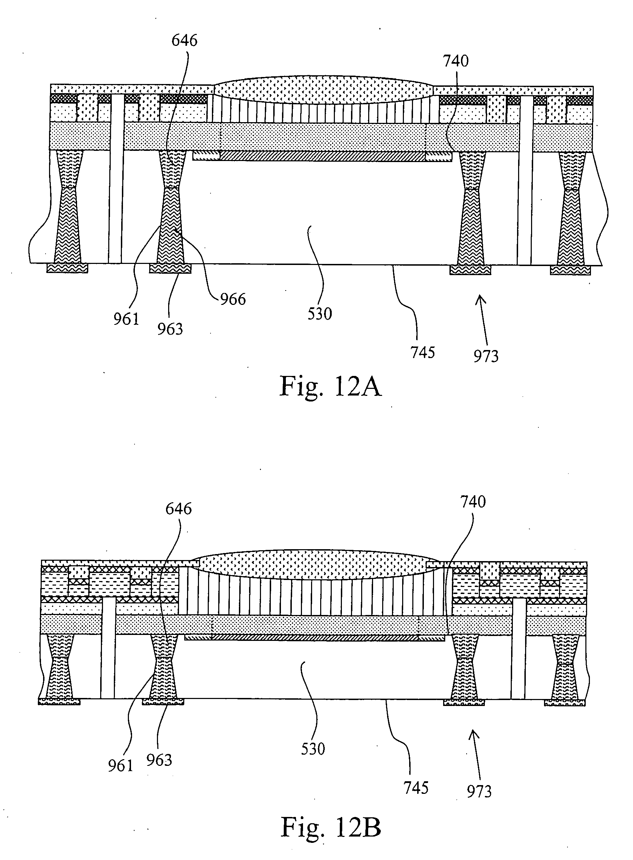

Fig. 12A and Fig. 12B illustrate schematic views of further preferred embodiments of the invention. Backside trenches 961 are formed in the lower surface 745 of the substrate 530, which may match up with the embedded frontside stitching plugs 646. As a result, the trenches 961 are completely coupled to the stitching plugs 646. It is noted that, in this embodiment, the substrate 530 can be thinned before the backside trenches 961 are formed, or after the stitching plugs 966 are formed.

The backside trenches 961 are formed by chemical etching, plasma etching or laser drilling from the backside surface 745. An insulating film is then formed on the exposed surfaces of backside trenches 961 by silicon oxidation, silicon nitride or polymer resin. Then, the backside trenches 961 having the insulating film are filled with conductive materials, such as titanium, titanium nitride, solder, copper, mercury, amalgam, aluminum, silver epoxy, conductive polymer, other conductive material or combinations thereof, to form conductive stitching plugs 966.

The lower surface 745 of the substrate 530 is sequentially patterned and etched to form stitching stud pads 963 so the stitching studs 973 is formed. In another embodiment, simple stitching studs are formed merely by forming the stitching plugs 966 and the insulating film but not the additional stitching stud pads 963.

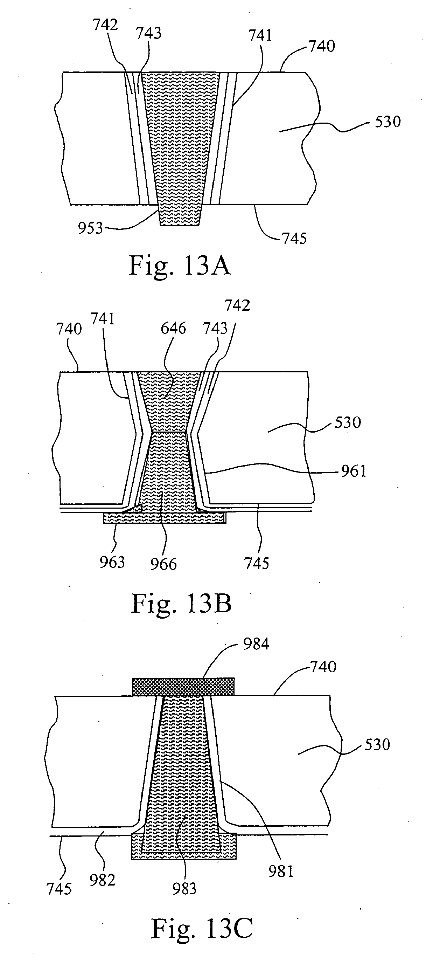

The stitching studs of the invention can be formed in many different ways. Figs. 13A - 13C illustrate schematic views of three embodiments of the invention to form the stitching studs. The two embodiments in Fig. 13A and Fig. 13B are interpreted as for the foregoing descriptions for Fig. 11A, Fig. 11B, and Fig. 12A, Fig. 12B.

As illustrated in Fig. 13C, after the substrate 530 is thinned or not, a backside stitching stud 983 is formed in a single backside trench 981 and passes through the substrate 530 from the lower surface 745 to the upper surface 740 thereof. It is noted that the lower surface 745 is covered by an insulating film 982. The stitching stud 983 is connected to an electrical connecting layer 984, whose material is a poly or polycide layer, a contact plug, or a metal layer, fabricated by the conventional way.

The foregoing image pickup device of the invention is further able to communicate with an image control module, a flexible conductive element and the like. Thus, the image pickup device may be a compact imaging module device suitable for a unit of portable electronic equipment.

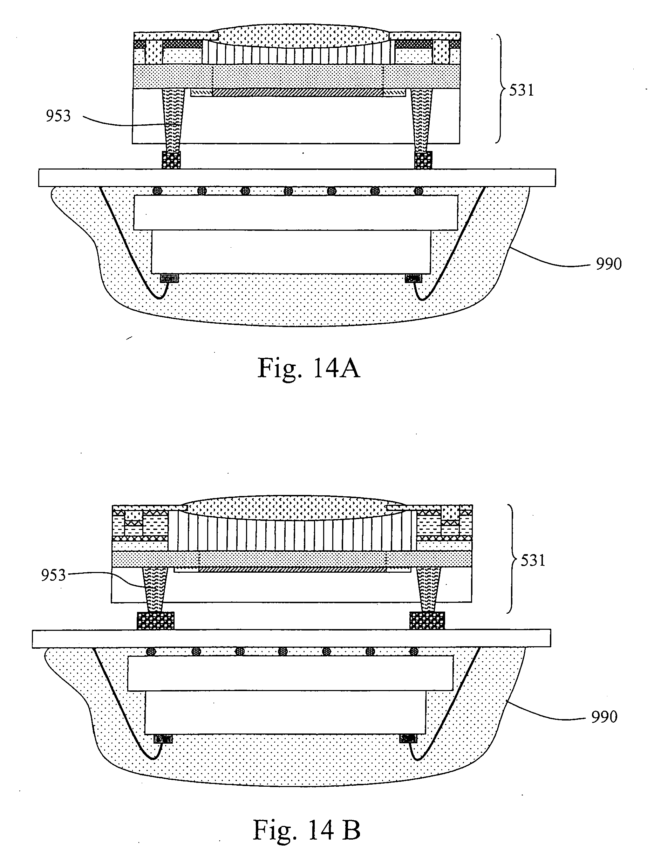

Fig. 14A and Fig. 14B illustrate schematic views of preferred embodiments of the image pickup device communicating with an image control module. The difference between the embodiments in Fig. 14A and Fig. 14B is that the embodiment of Fig. 14B has an additional sustain layer like the sustain layer 965 in Fig. 10B. Referring to Fig. 14A and Fig. 14B, a thin and compact imaging module is formed by the foregoing image chip 531 in Fig. 11A or Fig. 11B and electrically connected to an image control module in an integrated module circuit board 990 via the stitching studs 953. The integrated module circuit board 990 has highly integrated image related function blocks, such as system microcontrollers, digital signal processing units, system timing ASICs, memory buffers, and peripheral controller devices.

Several packaging connection techniques and materials, such as an isotropic conductive adhesive used in the stud bumping bonding, anisotropic connection film (ACF), gold or solder bumping, wiring, ball grid array, flexible cable and/or flip chip, can be used in the electrical connecting between the stitching studs 953 and the electrode ports of the integrated module circuit board 990 to form an integrated compact imaging module.

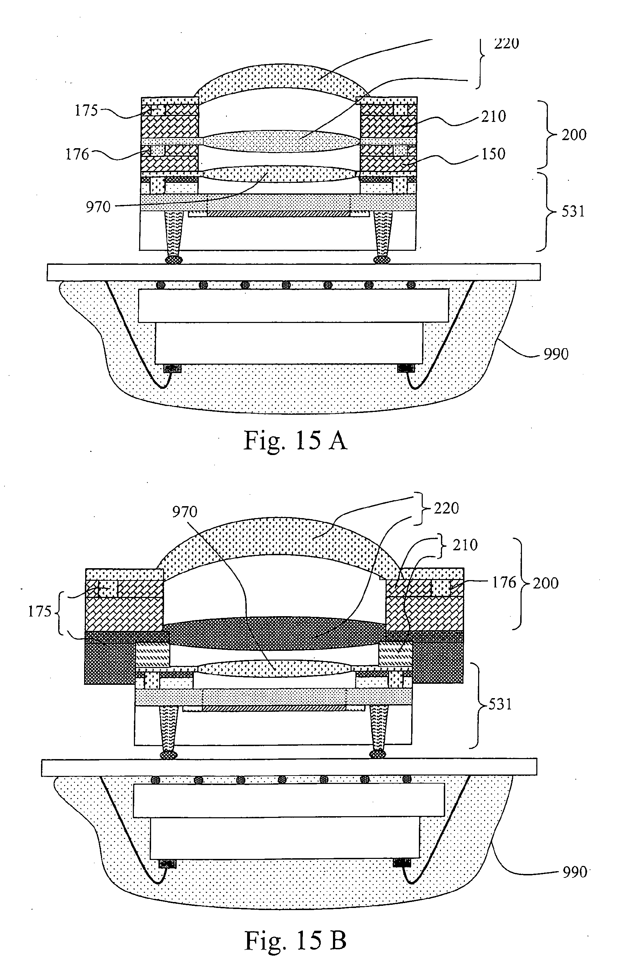

Fig. 15A and Fig. 15B illustrate schematic views of two embodiments of the imaging module of the invention with fixed focal lengths. Fig. 15B interprets another combined configuration of the optical lens system and the transparent window different from that illustrated in Fig. 15A. Referring to Fig. 15A and Fig. 15B, an optical lens system 200 includes an adhesive layer 210 and optics lenses 220. The optical lenses 220 can include spherical, aspherical, diffractive and/or refractive optical elements, or other refractive or diffractive optical elements obtained by a hybrid combined flat, spherical, aspherical, or Kinoform surfaces.

The optical lens system 200 can be directly configured on the upper surface of the transparent window 970 by using an adhesive layer 150 or even by inserting a sustain layer in between (not illustrated in figures) to combine the optical lens system 200 with the transparent window 970. In addition, a plurality of extrusions 175 can be formed in the optical lenses 220, and corresponding holes 176 are formed in the adhesive layer 210. Both of the extrusions 175 and the holes 176 thus facilitate the mechanical alignments.

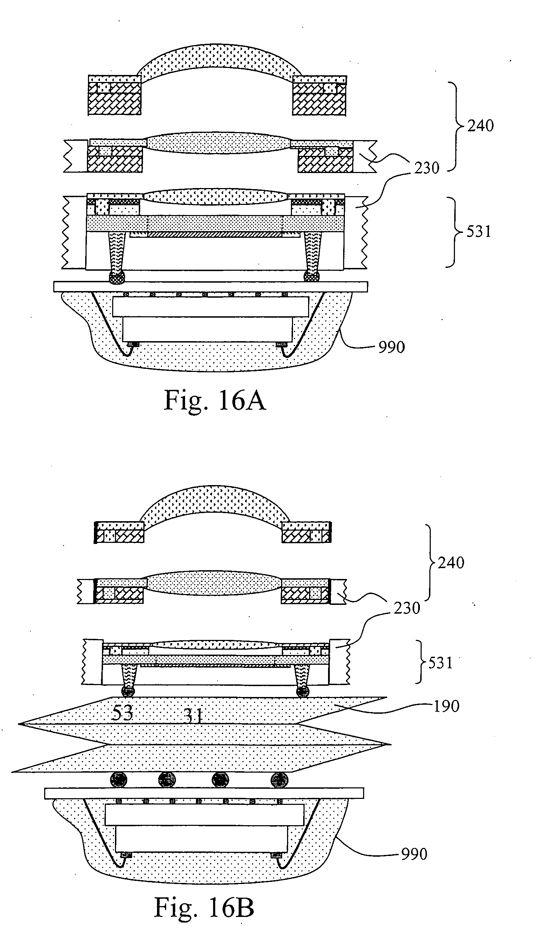

Fig. 16A and Fig. 16B illustrate schematic views of two embodiments of the imaging module of the invention with adjustable focal lengths. Fig. 16B interprets another combined configuration of the optical lens system whose transparent window is different from that in Fig. 16A. In Fig. 16A and 16B, zoom parts 230 are disposed between the optical lens system 240 and the image chip 531. In the preferred embodiments of the invention, the zoom parts 230 can be mechanical parts, electromagnetic force parts, motors, other types of zoom system or combinations thereof. An object of the zoom parts 230 of the invention is to achieve focus by moving the location of the image chip 531. The image chip 531 may communicate with the integrated module circuit board 990 as illustrated in Fig. 16A. Such arrangement may improve and magnify an object image.

It is noted that the image chip 531 can be electrically connected to the integrated module circuit board 990 with a flexible conductive element 190 as illustrated in Fig. 16B. In some preferred embodiments, the flexible conductive element 190 is a flexible circuit board, a conductive cable or member, or a conductive polymer.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. An image pickup device, comprising:
a substrate;
an electromagnetic receiving area on the substrate;
a peripheral circuit around the electromagnetic receiving area, and electrically connected to the electromagnetic receiving area; and
a plurality of stitching studs passing through the substrate, and electrically connected to the peripheral circuit.

2. The image pickup device of claim 1, wherein the image pickup device further comprises a transparent window, attached onto the substrate and located above the electromagnetic receiving area.

3. The image pickup device of claim 2, wherein the image pickup device further comprises an adhesive layer placed between the substrate and the transparent window.

4. The image pickup device of claim 2, wherein the image pickup device further comprises a sustain layer placed between the substrate and the transparent window.

5. The image pickup device of claim 2, wherein the image pickup device further comprises a plurality of holes and corresponding extrusions formed on adjacent surfaces of the substrate and the transparent window.

6. The image pickup device of claim 1, wherein the electromagnetic receiving area comprises a plurality of electromagnetic receiving elements.

7. An imaging module, comprising:
an image pickup device, comprising:
a substrate;
an electromagnetic receiving area on the substrate;
a peripheral circuit around the electromagnetic receiving area, and electrically connected to the electromagnetic receiving area; and
a plurality of stitching studs passing through the substrate, and electrically connected to the peripheral circuit;
an optical lens system, configured on the image pickup device with respect to the electromagnetic receiving area; and
an image control module, electrically connected to the stitching studs.

8. The imaging module of claim 7, wherein the image pickup device further comprises a transparent window, attached onto the substrate and located above the electromagnetic receiving area.

9. The imaging module of claim 7, wherein the imaging module further comprises an adhesive layer placed between the image pickup device and the optical lens system.

10. The imaging module of claim 7, wherein the imaging module further comprises a sustain layer placed between the image pickup device and the optical lens system.

11. The imaging module of claim 7, wherein the imaging module further comprises a plurality of holes and corresponding extrusions formed on adjacent surfaces of the image pickup device and the optical lens system.

12. The imaging module of claim 7, wherein the optical lens system is a fixed focal length type optical lens system or an adjustable focal length optical lens system.

13. The imaging module of claim 12, wherein when the optical lens system is the adjustable focal length optical lens system, the optical lens system and the image pickup device are configured with zoom parts to adjust a relative distance therebetween.

14. The imaging module of claim 7, wherein the imaging module further comprises a flexible conductive element connecting the image pickup device and the image control module.

15. A manufacturing method of an image pickup device, comprising:
providing a substrate;
forming an electromagnetic receiving area on a first surface of the substrate;
forming a peripheral circuit around the electromagnetic receiving area, wherein the peripheral circuit is connected to the electromagnetic receiving area; and
forming a plurality of stitching studs passing through the substrate, wherein the stitching studs are connected to the peripheral circuit.

16. The manufacturing method of claim 15, wherein the manufacturing method further comprises attaching a transparent window onto the substrate, wherein the transparent window is located above the electromagnetic receiving area.

17. The manufacturing method of claim 16, wherein the attaching step comprises providing an adhesive layer between the substrate and the transparent window.

18. The manufacturing method of claim 16, wherein the attaching step comprises forming a sustain layer between the substrate and the transparent window.

19. The manufacturing method of claim 16, wherein the attaching step comprises:
forming a plurality of holes and corresponding extrusions on adjacent surfaces of the substrate and the transparent window; and
matching the holes with the extrusions to combine the substrate and the transparent window.

20. The manufacturing method of claim 15, wherein the step of forming the stitching studs comprises:
forming a plurality of trenches in the first surface of the substrate;
forming insulating films inside the trenches;
filling the trenches with a conductive material to form a plurality of stitching plugs; and
thinning a second surface of the substrate to expose ends of the stitching plugs, thus obtaining the stitching studs.

21. The manufacturing method of claim 15, wherein the step of forming the stitching studs comprises:
forming a plurality of trenches in a second surface of the substrate;
forming insulating films inside the trenches; and
filling the trenches with a conductive material to form the stitching studs.

22. The manufacturing method of claim 15, wherein the step of forming the stitching studs comprises:
forming a plurality of first trenches in the first surface of the substrate;
forming a plurality of second trenches in a second surface of the substrate, wherein the second trenches match up with the first trenches;
forming insulating films inside the trenches; and
filling the trenches with a conductive material to form the stitching studs.

23. A manufacturing method of an imaging module, comprising:
providing an image pickup device, comprising:
providing a substrate;
forming an electromagnetic receiving area on a first surface of the substrate;
forming a peripheral circuit around the electromagnetic receiving area, wherein the peripheral circuit is connected to the electromagnetic receiving area; and
forming a plurality of stitching studs passing through the substrate, wherein the stitching studs are connected to the peripheral circuit;
configuring an optical lens system on the image pickup device with respect to the electromagnetic receiving area; and
electrically connecting an image control module to the stitching studs.

24. The manufacturing method of claim 23, wherein the manufacturing method further comprises attaching a transparent window onto the substrate, wherein the transparent window is located above the electromagnetic receiving area.

25. The manufacturing method of claim 23, wherein the configuring step comprises providing an adhesive layer between the image pickup device and the optical lens system.

26. The manufacturing method of claim 23, wherein the configuring step comprises forming a sustain layer between the image pickup device and the optical lens system.

27. The manufacturing method of claim 23, wherein the configuring step comprises:
forming a plurality of holes and corresponding extrusions on adjacent surfaces of the image pickup device and the optical lens system; and
matching the holes with the extrusions to combine the image pickup device and the optical lens system.

28. The manufacturing method of claim 23, wherein the step of forming the stitching studs comprises:
forming a plurality of trenches in the first surface of the substrate;
forming insulating films inside the trenches;
filling the trenches with a conductive material to form a plurality of stitching plugs; and
thinning a second surface of the substrate to expose ends of the stitching plugs, thus obtaining the stitching studs.

29. The manufacturing method of claim 23, wherein the step of forming the stitching studs comprises:
forming a plurality of trenches in a second surface of the substrate;
forming insulating films inside the trenches; and
filling the trenches with a conductive material to form the stitching studs.

30. The manufacturing method of claim 23, wherein the step of forming the stitching studs comprises:
forming a plurality of first trenches in the first surface of the substrate;
forming a plurality of second trenches in a second surface of the substrate, wherein the second trenches match up with the first trenches;
forming insulating films inside the trenches; and
filling the trenches with a conductive material to form the stitching studs.

31. The manufacturing method of claim 23, wherein the optical lens system is an adjustable focal length optical lens system, and the manufacturing method further comprises configuring zoom parts on the optical lens system and the image pickup device to adjust a relative distance therebetween.

32. The manufacturing method of claim 23, wherein the electrically connecting step comprises electrically connecting the image pickup device and the image control module with a flexible conductive element.

33. The manufacturing method of claim 23, wherein the image pickup device and the image control module are electrically connected by an isotropic conductive adhesive bumping bonding, surface mounting, anisotropic connection film (ACF), gold or solder bumping, wiring, ball grid array, flexible cable or flip chip.
